## Europäisches Patentamt
## European Patent Office
## Office européen des brevets

(11) Publication number: **0 104 850**
**B1**

(12) **EUROPEAN PATENT SPECIFICATION**

(45) Date of publication of patent specification: **11.07.90**

(51) Int. Cl.⁵: **G 06 F 11/00**

(21) Application number: **83305462.0**

(22) Date of filing: **16.09.83**

(54) Semiconductor memory device.

(30) Priority: **17.09.82 JP 161694/82**

(43) Date of publication of application:
**04.04.84 Bulletin 84/14**

(45) Publication of the grant of the patent:
**11.07.90 Bulletin 90/28**

(84) Designated Contracting States:
**DE FR GB**

(56) References cited:
**GB-A-2 027 958**
**US-A-3 036 272**
**US-A-4 337 525**

(73) Proprietor: **FUJITSU LIMITED**
**1015, Kamikodanaka Nakahara-ku**
**Kawasaki-shi Kanagawa 211 (JP)**

(72) Inventor: **Takemae, Yoshiro Shuwa-**
**Akasakahinokicho**
**Rejidensu 303 13-24, Akasaka 8-chome**
**Minato-ku Tokyo 107 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

Courier Press, Leamington Spa, England.

## Description

The present invention relates to a semiconductor memory device.

In a dynamic semiconductor memory device, an external address signal for reading is latched by the change of a clock signal. Since the address signal has been latched in the memory device, the reading operation will not be disturbed by subsequent noise.

A static semiconductor memory device, however, usually does not use a clock signal to latch an external address signal. Accordingly, in such static semiconductor memory devices, if an external address signal is disturbed by noise, the disturbed address signal is directly introduced into the internal circuit. Further, since the reading operation is effected at a high speed, completely erroneous data from the address may be read out from the memory device.

It is desirable to provide a static semiconductor memory device which can protect against the output of unwanted data from an address which, because of the effects of noise, has been erroneously accessed.

According to the present invention there is provided a memory device comprising: an array of memory cells; addressing circuitry for accessing selected memory cells, on the basis of address signals applied to the addressing circuitry when the device is in use, so as to make the contents of the selected memory cells available for reading into output buffer circuitry of the device; and data checking circuitry arranged and connected for reading an applied address signal, retaining the reading for a predetermined delay time, and comparing that reading with the said applied address signal as read at the end of the said predetermined delay time; characterised by inhibiting means for inhibiting such reading of cell contents into the said output buffer circuitry when the comparison carried out by the data checking circuitry reveals a difference between the two readings of the applied address signal, the device being such that during a period throughout which such inhibiting is occurring the said output buffer circuitry continues to output data read into it prior to commencement of that period.

US—A—4,337,525 proposes a memory device having an internal clock generator for producing a reset signal and an enable signal at the beginning of each new acccessing operation. Input address signals are supplied to the internal clock generator which detects the beginning of a new acccessing operation by comparing the newly-received address signals with address signals which have been retained previously in the internal clock generator for a predetermined delayed period. When one of the newly-received address signals differs from the corresponding retained address signal, because a new accessing operation has begun, the internal clock generator produces a reset signal of predetermined duration which is supplied to an address inverter/ tion which is supplied to an address inverter/ buffer circuit, a row decoder circuit, a column decoder circuit, a memory cell array and a column selection circuit of the memory device for resetting those circuits in preparation for the new accessing operation. After a predetermined period the reset signal ends and the internal clock generator then produces the enable signal which is supplied to all of the above-mentioned circuits to place those circuits in an enable condition. Accordingly, the prior art of US—A—4,337,525 is mainly concerned with providing internal clock signals in response to the beginning of a new accessing operation. However, the internal clock generator of US—A—4,337,525 can also detect the change in an address signal caused by noise, in the same way as it detects the beginning of a new accessing operation, and responds similarly to the noise in the address signal by supplying the reset signal for a predetermined period to each of the above-mentioned circuits of the memory device, whereafter the enable signal is produced. Thus, the memory device of US—A—4,337,525 differs from that of the present invention in that in the prior art device noise in the address signal causes the circuits in the device to be placed in a reset condition for a predetermined period, whereas according to the present invention only the operation of the output buffer circuitry is effected by the data checking circuitry when the latter circuitry detects noise in the address signal, the output buffer circuitry not being reset in such a case, but being merely inhibited from reading in new data. This allows the output buffer circuitry to continue to output data read in thereby prior to the inhibition of the output buffer circuitry.

Reference will now be made, by way of example, to the accompanying drawings, in which:

Fig. 1 is a block diagram of a prior static semiconductor memory device;

Fig. 2 is a time chart of a normal reading operation in the memory device of Fig. 1;

Fig. 3 is a time chart of an erroneous reading operation in the memory device of Fig. 1;

Fig. 4 is a block diagram of a static semiconductor memory device in accordance with one embodiment of the present invention;

Fig. 5 is a circuit diagram of one example of an address delay buffer for use in the memory device of Fig. 4;

Fig. 6 is a circuit diagram of one example of a comparator device for use in the memory device of Fig. 4;

Fig. 7 is a circuit diagram of one example of a data buffer for use in the memory device of Fig. 4; and

Fig. 8 is a time chart of a reading operation of the memory device of Fig. 4.

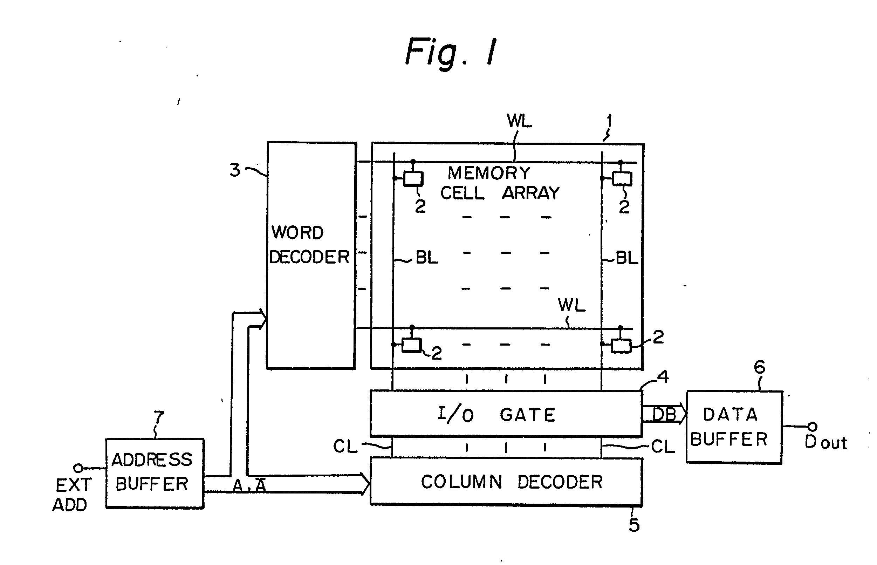

Fig. 1 illustrates a static semiconductor memory device. The memory device of Fig. 1 comprises a memory cell array 1 including a large number of static memory cells 2 arranged in a matrix fashion, a word decoder 3 for selecting one of a plurality of word lines WL, an input-output gate 4 coupled to a plurality of bit lines BL, a column decoder 5 for supplying the input-output gate 4 with a bit line selecting signal through the column lines CL, a data buffer 6 for outputting data, read out from the input-output gate 4 onto a data bus DB, to the outside, and an address buffer 7 for receiving an external address signal EXT ADD and for supplying an internal address signal A and its inverted signal $\overline{A}$ to the word decoder 3 and the column decoder 5.

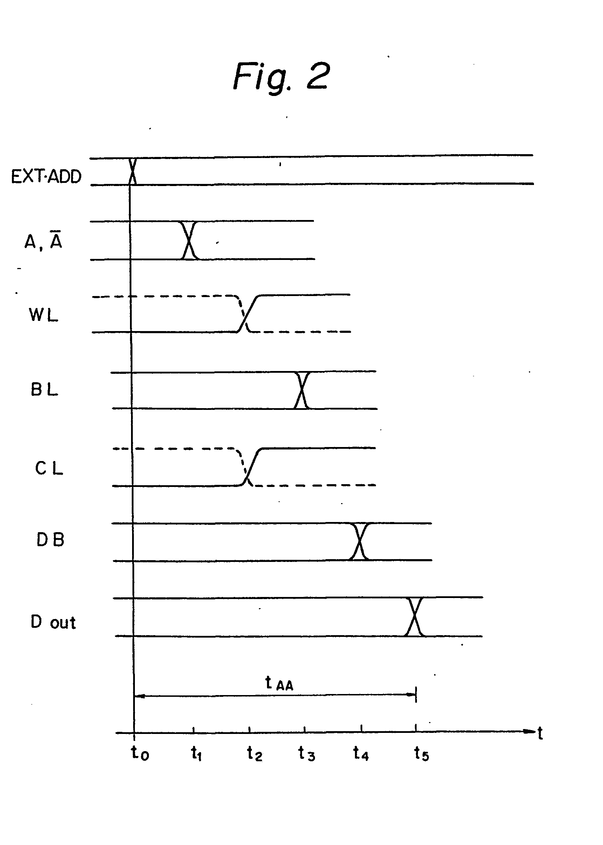

A time chart illustrating normal operation of the memory device of Fig. 1 is given in Fig. 2. Assume that the external address signal EXT ADD is changed at a time $t_0$. The internal address signal, A, $\overline{A}$ is then changed at a time $t_1$, and the reading (accessing) operation for the new address is started. The word line WL and the column line CL corresponding to the new address are selected at a time $t_2$. The new data from the cell selected by the new world line WL is output on a bit line BL at a time $t_3$, and the data corresponding to the new address is output on the data bus DB at a time $t_4$. The output $D_{out}$ of the data buffer 6 is changed to the data corresponding to the new address at a time $t_5$. Thus, the access time for reading of this memory device is $T_{AA}$ (= $t_5-t_0$).

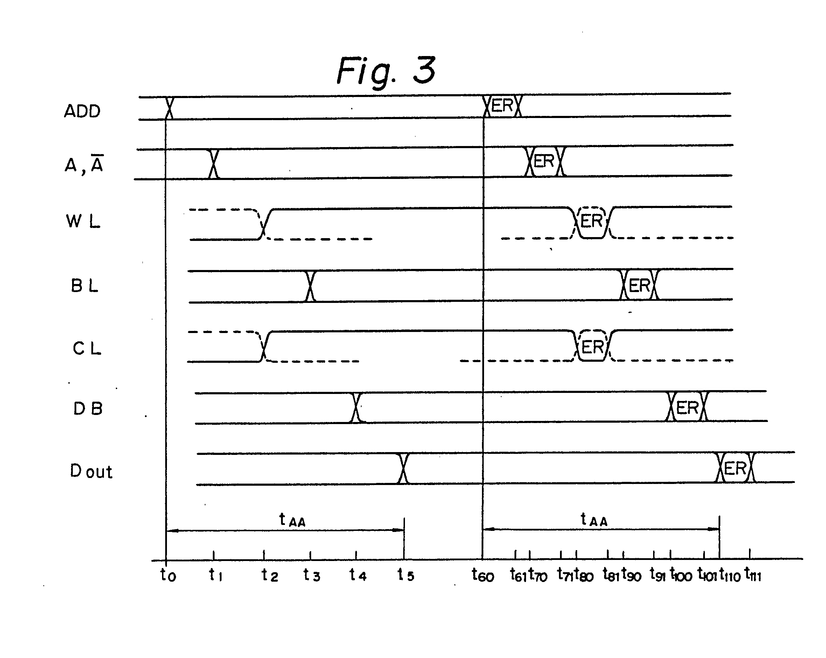

In the static semiconductor memory device of Fig. 1, since the operation speed of the static memory device is high, the output data may be influenced by transient noise affecting the external address signal EXT ADD. A time chart of an erroneous operation due to transient noise in the memory device of Fig. 1 is given in Fig. 3. The external address signal EXT ADD is normally changed at the times $t_0$ and $t_0'$ (after $t_{110}$). However, before $t_0'$ (for example, between times $t_{60}$ and $t_{61}$) it is possible that there will be a transient erroneous change in the external address signal EXT ADD as a result of noise. In this case, the internal address signal A, $\overline{A}$ is changed erroneously between times $t_{70}$ and $t_{71}$, the world line WL and the column line CL corresponding to the erroneous address are selected erroneously between times $t_{80}$ and $t_{81}$, data from the cell corresponding to the erroneous address is output on a bit line BL between times $t_{90}$ and $t_{91}$, the data for the memory cell corresponding to the erroneous address is read out onto the data bus DB between times $t_{100}$ and $t_{101}$, and erroneous output data $D_{out}'$ is output from the data buffer between times $t_{110}$ and $t_{111}$. That is, the output data $D_{out}$ is changed erroneously at the time $t_{110}$, which is later than the time $t_{60}$ by the above-mentioned access time $t_{AA}$. The output data $D_{out}$ returns to normal at the time $T_{111}$. Accordingly, in the illustrated semiconductor memory device of Fig. 1, noise may cause erroneous data to be output. This data may be used as the read-out data in error.

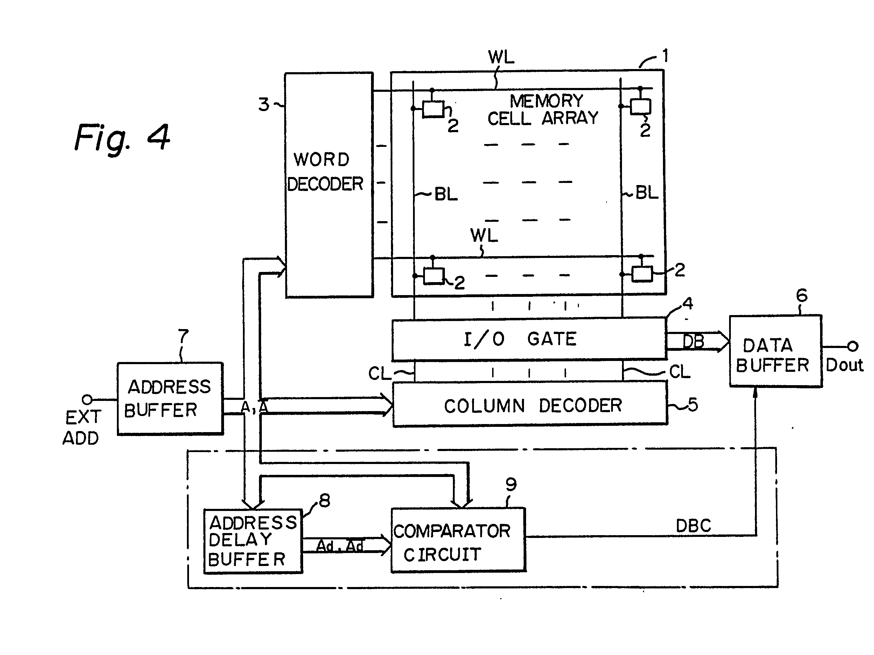

A static semiconductor memory device in accordance with one embodiment of the present invention will now be described. Fig. 4 is a block diagram of such a semiconductor memory device. In Fig. 4, portions corresponding to those in Fig. 1 bear the same reference numerals. The memory device of Fig. 4 further comprises data checking circuitry constituted by an address delay buffer 8 and a comparator circuit 9.

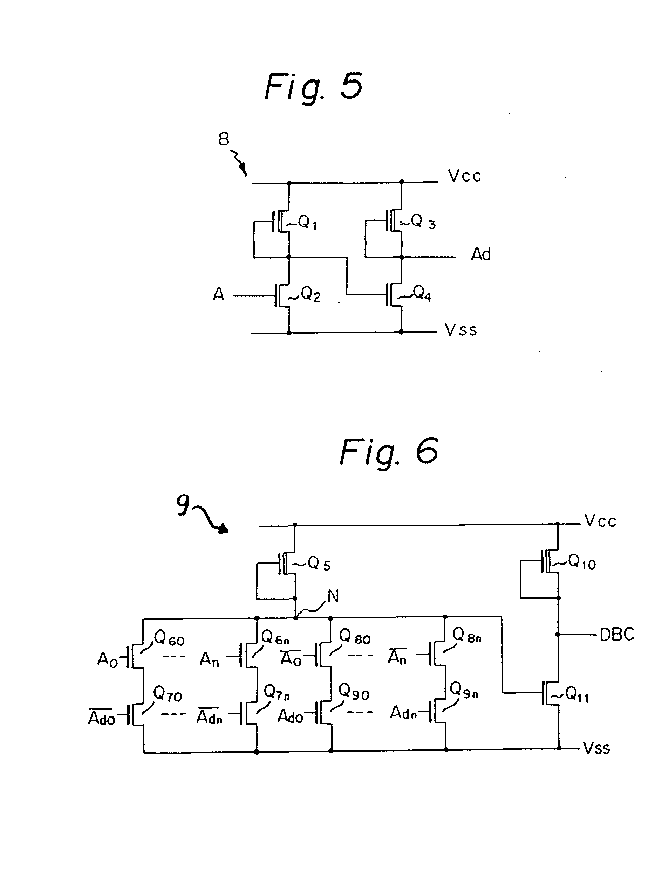

The address delay buffer 8 produces address signals Ad, $\overline{Ad}$ which are delayed by a predetermined time from the internal address signal A, $\overline{A}$. An example of the circuit structure of the address delay buffer 8 is illustrated in Fig. 5. In the circuit of Fig. 5, transistors $Q_1$ and $Q_2$ form a first stage inverter, and transistors $Q_3$ and $Q_4$ form a second stage inverter. The transistors $Q_1$ and $Q_3$ are depletion-type field-effect transistors (FET's). The internal address signal A is delayed by the first and second stage inverters to obtain a delayed address signal Ad. The inverter internal address signal $\overline{A}$ is delayed by the same circuit to obtain a delayed inverted address signal $\overline{Ad}$. The number of stage inverters may be increased in accordance with the required delay time $t_D$.

The comparator circuit 9 of Fig. 4 compares the internal address signals, A, $\overline{A}$ with the corresponding delayed address signal Ad, $\overline{Ad}$ and, in accordance with the result of the comparison, produces a data buffer control signal DBC for making the data buffer 6 operable only when the internal address signals A, $\overline{A}$ and the corresponding delayed address signals Ad, $\overline{Ad}$ are equal to each other. An example of the structure of the comparator circuit 9 is illustrated in Fig. 6. the circuit of Fig. 6 comprises transistors, $Q_5$, $Q_{60}$ to $Q_{6n}$, $Q_{70}$ to $Q_{7n}$, $Q_{80}$ to $Q_{8n}$, $Q_{90}$ to $Q_{9n}$, $Q_{10}$ and $Q_{11}$. The transistors $Q_5$ and $Q_{10}$ are depletion-type FET's. The transistor pairs $Q_{60}$ and $Q_{70}$, ..., $Q_{6n}$ and $Q_{7n}$, $Q_{80}$ and $Q_{90}$, ..., and $Q_{8n}$ and $Q_{9n}$ are each connected in series between the source of the transistor $Q_5$ and the ground $V_{SS}$. Bits $A_0$, ..., $A_n$ of the internal address signal A are applied to the gates of the transistors $Q_{60}$, ..., $Q_{6n}$ respectively; bits $\overline{Ad_0}$, ... $\overline{Ad_n}$ of the delayed inverted address signal 7Ad are applied to the gates of the transistors $Q_{70}$, ..., $Q_{7n}$ respectively; bits $\overline{A_0}$, ..., $\overline{A_n}$ of the inverted address signal $\overline{A}$ are applied to the gates of the transistors $Q_{80}$, ..., $Q_{8n}$ respectively, and bits $Ad_0$, ..., $Ad_n$ of the delayed address signal Ad are applied to the gates of the transistors $Q_{90}$, ..., $Q_{9n}$ respectively.

In the comparator circuit 9 of Fig. 6, when the internal address signal, A, $\overline{A}$ and the delayed address signals Ad, $\overline{Ad}$ are equal to each other in all bits (that is, $A_i = Ad_i$ and $\overline{A_i} = \overline{Ad_i}$), one transistor in each of the series-connected transistor pairs $Q_{60}$ and $Q_{70}$, ..., $Q_{6n}$ and $Q_{7n}$, $Q_{80}$ and $Q_{90}$, ..., and $Q_{8n}$ and $Q_{9n}$ turns off. Thus, all these series-connected transistor pairs turn off. Accordingly, the level of the node N (the source of the transistor $Q_5$) becomes the "H" level, the transistor $Q_{11}$ turns on, and the output DBC becomes the "L" level. On the other hand, if even one correspondingly bit of the internal address signals A, $\overline{A}$ and the delayed address signal Ad, $\overline{Ad}$ are not equal to each other (for example $A_0 = Ad_0$), both transistors in one of the series-conducted transistor pairs remain on, and the node N becomes the "L" level. For example, if $A_0 = \overline{Ad_0} = $ "H", then the transistors $Q_{60}$ and $Q_{70}$ are both on. If $A_0 = \overline{Ad_0} = $ "L", then $\overline{A_0} = Ad_0 = $ "H" and the

transistors $Q_{80}$ and $Q_{90}$ are both on. In these cases, the output DBC of the comparator becomes the "H" level.

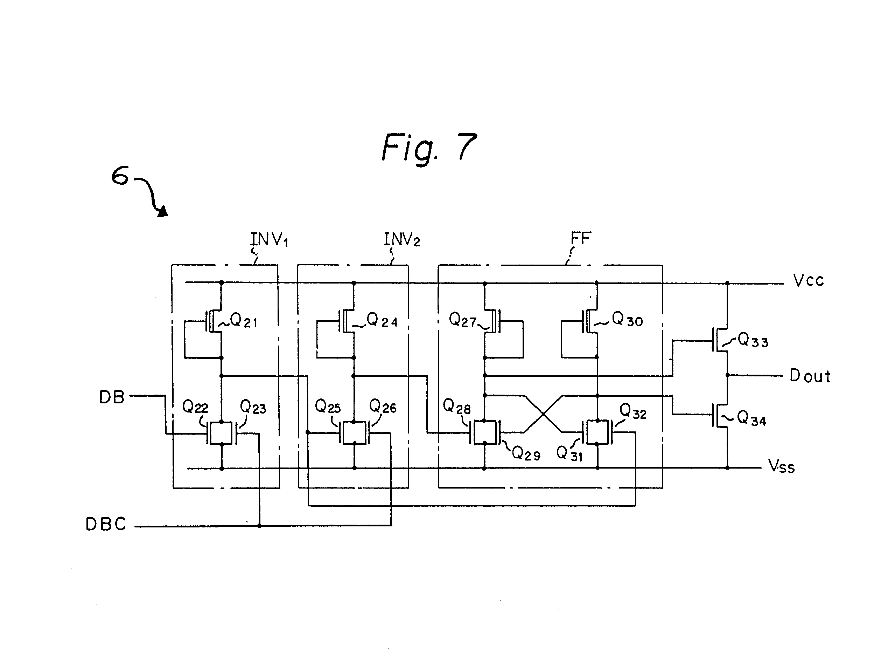

An example of the structure of the data buffer 6 in Fig. 4, which is controlled by the control signal DBC, is illustrated in Fig. 7. In Fig. 7, transistors $Q_{21}$, $Q_{22}$ and $Q_{23}$ form a first-stage inverter $INV_1$. Transistors $Q_{24}$, $Q_{25}$ and $Q_{26}$ form a second stage inverter $INV_2$ which inverts the output of the first-stage inverter $INV_1$. The transistor $Q_{23}$ is connected in parallel with the transistor $Q_{22}$, and the transistor $Q_{26}$ is connected in parallel with the transistor $Q_{25}$. The control signal DBC is applied to the gates of the transistors $Q_{23}$ and $Q_{26}$. When the control signal DBC is "H", the data reading operation of the data buffer 6 is inhibited. Transistors $Q_{27}$ through $Q_{32}$ form a flip-flop circuit FF. The outputs of the inverters $INV_1$ and $INV_2$ set or reset the flip-flop circuit FF in accordance with the level of the data on the data bus DB.

When the control signal DBC is the "L" level, the output of the flip-flop circuit FF turns output-stage transistors $Q_{33}$ and $Q_{34}$ on or off in accordance with the input data. The output data $D_{out}$ read out from the memory device is produced by the output-stage transistors $Q_{33}$ and $Q_{34}$.

When the control signal DBC is the "H" level, the transistors $Q_{23}$ and $Q_{26}$ become on, and the outputs of the inverters $INV_1$ and $INV_2$ becomes the "L" level, regardless of the input data. In this case, the transistors $Q_{28}$ and $Q_{32}$ in the flip-flop circuit FF become off, and the output of the flip-flop circuit FF is kept at its previous value.

In the static semiconductor memory device of Fig. 4, the reading operation of the data buffer 6 is inhibited when erroneous data is output as a result of noise from the input-output gate circuit 4 on the data bus DB, so that this erroneous data does not appear in the output data $D_{out}$.

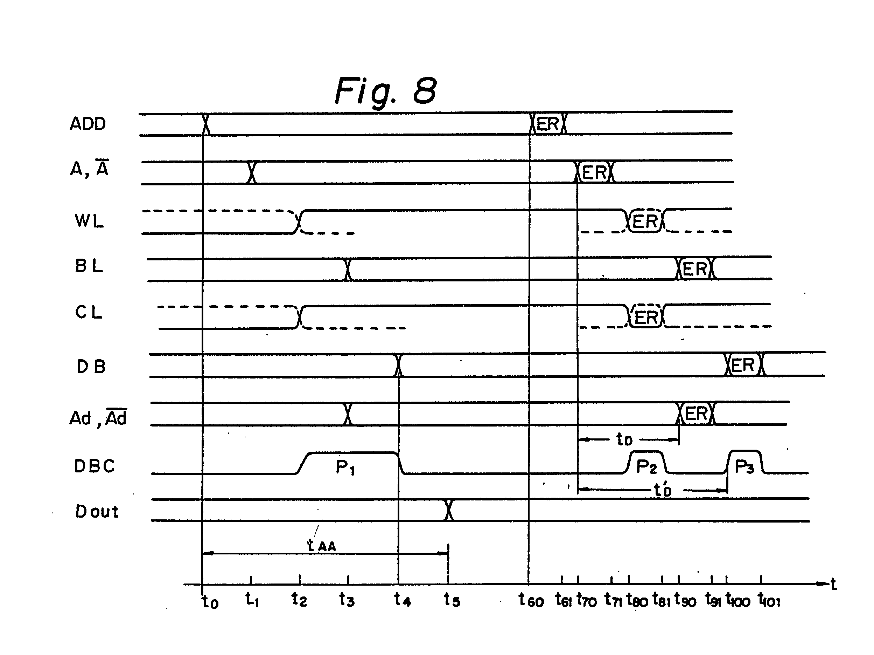

Fig. 8 is a time chart of the reading operation of the memory device of Fig. 4. In Fig. 8, the external address signal EXT ADD is changed at a time $t_0$ and is disturbed by noise between times $t_{60}$ and $t_{61}$, as in Fig. 3. Changes in the internal address signals A, $\overline{A}$, the selection of the word line WL, the column line CL, and the bit line BL, and the data bus output DB occur as in Fig. 3. Delayed address signals Ad, $\overline{Ad}$ corresponding to the erroneous internal address signals A, $\overline{A}$ changed at the time $t_1$ are produced by the address delay buffer 8 at a time later than the time $t_{70}$ by a delay time $t_D$. The data buffer control signal DBC from the comparator circuit 9 becomes the "H" level in the periods $P_1$, $P_2$ and $P_3$. The delay time $t_D$ is predetermined by the circuitry in the address delay buffer 8 in such a way that the third period $P_3$ coincides with the period between the times $t_{100}$ and $t_{101}$ in which the erroneous data resulting from the noise is output from the input-output gate circuit 4 onto the data bus DB. The length of the delay time $t_D$ is determined by considering the delay from the change of the address to the change of the output data, the operation delay in the comparator circuit 9, etc . . .

Since the reading operation of the data buffer 6 is inhibited in the period in which the erroneous data resulting from the noise is output on the data bus DB, as described above, the erroneous data is not read into the data buffer 6, and the data buffer 6 continues to output normal data in the corresponding period.

In Fig. 8, though the data buffer control signal DBC becomes the "H" level in the periods $P_1$ and $P_2$, in addition to the period $P_3$, it does not influence the reading operation of the memory device of Fig. 4 at such times, as described below. As the period $P_1$ is finished at the time $t_4$ and as the data, corresponding to the address change at the time $t_0$, is output onto the data bus DB at the time $t_4$, this data is read into the data buffer 6, and the output data $D_{out}$ is changed at time $t_5$. Thus, the access time for reading in the memory device of Fig. 4 is $t_{AA}$, just as in the memory device of Fig. 1. Besides, since the normal data is read into the data buffer 6 before the period $P_2$, even if the reading operation of the data buffer 6 is inhibited in the period $P_2$, the data buffer 6 continues to output normal data.

In the static semiconductor memory device described above, even if the input address signal is disturbed by noise, data accessed erroneously owing to the noise can be prevented from being output externally.

A memory device embodying the present invention may be formed on a single or plurality of semiconductor substrates.

**Claims**

1. A memory device comprising: an array (1) of memory cells (2); addressing circuitry (3, 5, 7) for accessing selected memory cells, on the basis of address signals applied to the addressing circuitry when the device is in use, so as to make the contents of the selected memory cells available for reading into output buffer circuitry (6) of the device; and data checking circuitry (8, 9) arranged and connected for reading an applied address signal, retaining the reading for a predetermined delay time, and comparing that reading with the said applied address signal as read at the end of the said predetermined delay time;

characterised by inhibiting means (DBC) for inhibiting such reading of cell contents into the said output buffer circuitry (6) when the comparison carried out by the data checking circuitry (8, 9) reveals a difference between the two readings of the applied address signal, the device being such that during a period throughout which such inhibiting is occurring the said output buffer circuitry (6) continues to output data read into it prior to commencement of that period.

2. A device as claimed in claim 1, wherein that device is a static semiconductor memory device.

3. A device as claimed in claim 2, wherein that device is formed of one semiconductor substrate.

4. A device as claimed in claim 2, wherein that device is formed on several semiconductor substrates.

**Patentansprüche**

1. Speichervorrichtung mit: einer Anordnung (1) aus Speicherzellen (2); Adressierschaltungen (3, 5, 7) zum Adressieren ausgewählter Speicherzellen, auf der Basis von Adreßsignalen, die den Adressierschaltungen zugeführt werden, wenn die Vorrichtung in Betrieb ist, um so die Inhalte der ausgewählten Speicherzellen zum Lesen in Ausgangspufferschaltungen (6) der Vorrichtung verfügbar zu machen; und Datenprüfschaltungen (8, 9), die angeordnet und verbunden sind, um ein zugeführtes Adreßsignal zu lesen, die Lesung für eine vorbestimmte Verzögerungszeit zurückzuhalten und die Lesung mit dem genannten zugeführten Adreßsignal, wie es an dem Ende der genannten vorbestimmten Verzögerungszeit gelesen wird, zu vergleichen;

gekennzeichnet durch Sperreinrichtungen (DBC) zum Sperren solchen Lesens von Zellinhalten in die genannte Ausgangspufferschaltung (6), wenn der durch die Datenprüfschaltung (8, 9) durchgeführte Vergleich einen Unterschied zwischen den beiden Lesungen der zugeführten Adreßsignale aufdeckt, welche Vorrichtung derart ist, daß während einer Periode, während welcher durchweg solch ein Sperren auftritt, die genannte Ausgangspufferschaltung (6) fortfährt, Daten auszugeben, die vor Beginn jener Periode in sie eingelesen wurden.

2. Vorrichtung nach Anspruch 1, bei der die Vorrichtung eine statische Halbleitervorrichtung ist.

3. Vorrichtung nach Anspruch 2, bei der die Vorrichtung auf einem Halbleitersubstrat geformt ist.

4. Vorrichtung nach Anspruch 2, bei der die Vorrichtung auf mehreren Halbleitersubstraten geformt ist.

**Revendications**

1. Dispositif de mémoire comprenant: une matrice (1) de cellules de mémoire (2); des circuits d'adressage (3, 5, 7) pour avoir accès à des cellules de mémoire sélectionnées, en fonction de signaux d'adresse appliquées aux circuits d'adressage quand le dispositif est en fonctionnement, de manière à rendre disponibles les contenus des cellules de mémoire sélectionnées pour un lecture par des circuits tampons de sortie (6) du dispositif; et des circuits de contrôle de données (8, 9) disposés et connectés pour lire un signal d'adresse appliqué, maintenir la lecture pendant un retard de temps prédéterminé, et comparer cette lecture au signal d'adresse appliqué tel que lu à la fin du retard de temps prédétermine;

caractérisé par un moyen d'invalidation (DBC) pour invalider cette lecture des contenus de cellules par les circuits tampons de sortie (6) quand la comparaison exécutée par les circuits de contrôle de données (8, 9) révèle une différence entre les deux lectures du signal d'adresse appliqué, le dispositif étant tel que, pendant toute la période où cette invalidation se produit, les circuits tampons de sortie (6) continuent à sortir des données lues par ceux-ci avant le commencement de cette période.

2. Dispositif selon la revendication 1, dans lequel ce dispositif est un dispositif de mémoire statique à semiconducteur.

3. Dispositif selon la revendication 2, dans lequel ce dispositif est formé sur un substrat semiconducteur.

4. Dispositif selon la revendication 2, dans lequel ce dispositif est formé sur plusieurs substrats semiconducteurs.

## Fig. I

EP 0 104 850 B1

# Fig. 2

EXT·ADD

A, $\overline{A}$

WL

BL

CL

DB

D out

$t_{AA}$

$t_0$  $t_1$  $t_2$  $t_3$  $t_4$  $t_5$

t

Fig. 3

Fig. 4

EP 0 104 850 B1

## Fig. 5

## Fig. 6

## Fig. 7

# Fig. 8

ADD

A, $\overline{A}$

WL

BL

CL

DB

Ad, $\overline{Ad}$

DBC

Dout

$t_0$  $t_1$  $t_2$  $t_3$  $t_4$  $t_5$   $t_{60}$  $t_{61}$  $t_{70}$  $t_{71}$  $t_{80}$  $t_{81}$  $t_{90}$  $t_{91}$  $t_{100}$  $t_{101}$

EP 0 104 850 B1